# EUROPEAN PATENT APPLICATION

(11) **EP 1 096 845 A1**
(43) Date of publication of application: **02.05.2001**
(21) Application number: 00308811.9
(22) Date of filing: 06.10.2000
(51) Int. Cl.: H05K 9/00, H01J 9/20, H01J 17/16, H01J 29/86

(54) **Transparent electromagnetic radiation shield material and method of producing the same**

(30) Priority: 25.10.1999 JP 33833099
(71) Applicant: NISSHINBO INDUSTRIES, INC., Chuo-ku, Tokyo (JP)
(72) Inventor: Marutsuka, Toshinori, c/o Nisshinbo Industries, Chiba-shi, Chiba (JP)
(74) Representative: Stuart, Ian Alexander

(57) **Abstract**

A transparent electromagnetic radiation shield material includes a transparent base material (1), and a black metallic oxide layer (2) and metallic layer (3), or a metallic layer (3) and black metallic oxide layer (2), of identical mesh pattern successively laminated in alignment on the transparent base material (1) by dry plating, a portion of the black metallic oxide layer (2) on the metallic layer (3) optionally being removed.

Although the two layers (the black metallic oxide layer and metallic layer or the metallic layer and black metallic oxide layer) laminated on the transparent base material can be given identical aligned mesh patterns by direct processing with a laser beam or the like after laminating the two layers, ordinarily either blasting and/or etching or liftoff is used for this purpose.

## Description

### BACKGROUND OF THE INVENTION

### Field of the Invention

This invention relates to a transparent electromagnetic radiation shield material for placement in front of a display device or the like to block electromagnetic radiation, and to a method of producing the material. The transparent electromagnetic radiation shield material is particularly suitable for a panel for a large plasma display.

### Description of the Background Art

An electromagnetic radiation shield material for placement in front of a display device or the like is required to have not only excellent electromagnetic radiation shielding capability but also excellent transparency (optical transmittance), good clarity (degree of coating blackness etc.), wide viewing angle and the like. Japanese Patent Application Laid-Open Nos. 10-56289 ('289), 10-56290 ('290) and 10-41682 ('682) teach electromagnetic radiation shield materials meeting these requirements to some extent.

Specifically, '289 teaches that "a 35-µm thick copper foil serving as a metallic layer was laminated onto a 100-µm thick polyester film serving as a transparent base material and the metallic layer was patterned into a grid of 10-µm line width and 100 x 100-µm mesh size by photolithography. After connection of conductor wires, the result was immersed in an aqueous solution containing 1 % of carbon black, 20 % of aminated-epoxidated polybutadiene (number average molecular weight: 1000) and 1 % of triethylamine and applied with 10 V for 1 min to form a 1-µm thick black electrodeposited layer. The plate was dried at 60 °C for 30 min and cooled, whereafter a film was laminated thereon to obtain a translucent electromagnetic radiation shield material."

The invention of '290 is described as follows: "As a transparent base plate provided on one surface with a metallic layer was used 100-µm thick polyester film laminated with a 35-µm thick iron foil. Positive type photoresist (OFPR 800, product of Tokyo Ohka Kogyo Co., Ltd.) was formed on the iron foil and patterned into a grid of 10-µm width, 100 x 100-µm mesh size by exposure using a photomask and development. After removal of the unprotected iron foil portions with an aqueous etching solution of ferric chloride, the resist was peeled off. The result was immersed for 2 min in an 80 °C aqueous solution containing 0.1 M of zinc dihydrogenphosphate to convert the surface layer portion of the metallic layer into a metal oxide exhibiting blackness and obtain a translucent electromagnetic radiation shield material."

On the other hand, '682 teaches a method wherein "lines constituting a geometric pattern drawn on the surface of a transparent plastic base material with an electrically conductive material have a line width of 40 µm or less, a line interval of 200 µm or greater and a line thickness of 40 µm or less, part or the whole surface of the base material including the geometric pattern is coated with an adhesive, the difference between the refractive indices of the adhesive coating the geometric pattern and the transparent plastic base material is made 0.14 or less or, if the transparent plastic base material is laminated on an electrically conductive material via an intervening adhesive layer, the difference between the refractive indices of the adhesive layer and adhesive coating the geometric pattern is made 0.14 or less, to obtain an adhesive film having electromagnetic radiation shielding property and transparency, and the result is used as a display electromagnetic radiation shielding component."

In the invention of '289, however, the black (electrodeposited) layer (1) is blackish (gray-black) and low in degree of blackness and (2) is very bad in clarity owing to uneven blackness attributable to the difficulty of forming the black layer with uniform thickness. Moreover, when a black (electrodeposited) layer is formed after metallic layer patterning, the black layer is deposited also at the side surface of the metallic layer and becomes a cause for degradation of optical transmittance and clogging. (On the other hand, if the black (electrodeposited) layer is formed before metallic layer patterning, the processing precision is low because, for example, the unevenness in black layer thickness appears as unevenness in line width after etching of the metallic layer and the black layer.)

In the invention of '290, the shielding performance is poor owing to the blackening of the surface of the metallic layer by oxidation. In addition, the black layer (blackened by oxidation) has low blackness in the brown-black range and is therefore poor in clarity.

On the other hand, '682 is low in electromagnetic wave radiation shielding performance because the line interval (opening width) is 200 µm or greater and the thick (3-40 µm) conductive layer makes the viewing angle narrow. For patterning in the chemical etching process, moreover, the only black layer usable when the electrically conductive material is copper (foil) is a black metallic layer soluble in the etching solution. Production of this black metallic layer is, however, very time-consuming and costly because it is formed by the wet chemical process widely used for copper (foil) roughening in the ordinary printed circuit board field (commonly called brown processing or black processing because the copper color is changed to brown or black by processing in an aqueous solution or the like of sodium chlorite, sodium hydroxide or trisodium phosphate). Another problem is a low degree of blackness (brown-black) that makes clarity poor.

Since the black metallic layer is formed by oxidizing the surface layer of the copper (foil), moreover, the thickness of the formed metallic copper (foil) is reduced by the same amount and is therefore lowered in conductivity (electromagnetic wave radiation shielding performance).

In addition, the roughness of the black metallic layer surface makes its etchability extremely bad (formation of patterns with line interval under 200 µm is difficult) and the surface roughness of the black metallic layer transfers to the adhesive layer at etched portions to make it non-transparent (like frosted glass). As use is impossible without restoring transparency, the adhesive layer is fused and press-bonded (with simultaneous lamination to the base material). This process is conducted at a high temperature of around 110 °C, limiting the type of base material to which it can be applied. (It cannot be practically applied to general-purpose acrylic plastic base materials or other such materials with low heat resistance because it causes them to warp markedly.) Even though the adhesive layer is made transparent by the fusing and press-bonding, the clarity (optical transmittance) is still lower than in the absence of an adhesive layer.

### BRIEF DESCRIPTION OF THE DRAWINGS

Figure 1 is a sectional view of a transparent electromagnetic radiation shield material that is an embodiment of present invention.
Figure 2 is a sectional view of a transparent electromagnetic radiation shield material that is an embodiment of present invention.

### SUMMARY OF THE INVENTION

The present invention overcomes the foregoing problems by providing:
(1) A transparent electromagnetic radiation shield material comprising a transparent base material, and a black metallic oxide layer and metallic layer, or a metallic layer and black metallic oxide layer, of identical mesh pattern successively laminated in alignment on the transparent base material by dry plating, a portion of the black metallic oxide layer on the metallic layer optionally being removed.
(2) A method of producing a transparent electromagnetic radiation shield material comprising a step of successively forming on a transparent base material by dry plating a black metallic oxide layer and metallic layer, or a metallic layer and black metallic oxide layer, a step of forming a mesh-like resist layer thereon, a step of removing portions of the black metallic oxide layer and metallic layer or the metallic layer and black metallic oxide layer not protected by the resist layer by sand-blasting and/or dissolution with an etching solution to form a mesh pattern corresponding to the mesh-like resist layer, and an optional step of peeling off the resist layer and/or coating the mesh-like pattern side (side remote from the transparent base material) with transparent resin.
(3) A method of producing a transparent electromagnetic radiation shield material comprising a step of forming resist on a transparent base material in a reverse-mesh pattern, a step of successively forming thereon (on the surface of the transparent base material portion and the resist portion) by dry plating a black metallic oxide layer and metallic layer, or a metallic layer and black metallic oxide layer, and a step of removing only the black metallic oxide layer and metallic layer, or the metallic layer and black metallic oxide layer, on the resist portion surface by peeling off the resist (liftoff process).

### DETAILED DESCRIPTION OF THE PREFERRED EMBODIMENTS

The base material used in this invention is selected based on intended purpose. It is required to be transparent. It is selected according to intended use from among various materials including, for example, glass plate, plastic film, plastic sheet and plastic plate. The shape of the base material is not particularly limited.

When the transparent base material is a continuous web (roll) of film, sheets of different sizes can be easily cut from the obtained transparent electromagnetic radiation shield film while avoiding inclusion of defective portions. This is advantageous from the points of high yield and economy. Since the roll film can be produced by a continuous process, its productivity is higher than when the transparent base material is plate-like. Owing to its flexibility, moreover, the film can also be used to produce curved shields.

The present invention also enables fabrication of a transparent electromagnetic radiation shield panel by laminating the transparent electromagnetic radiation shield film by its electromagnetic wave shielding layer surface to a display panel or a transparent base plate, using an intervening transparent adhesive.

A plastic used as the base material is preferably a resin with high transparency. Preferable examples include acrylic resins, polycarbonate, polyethylene, AS resins, vinyl acetate resin, polystyrene, polypropylene, polyester, polysulfone, polyethersulfone, polyvinylchloride, olefine-maleimide copolymer, and norbornene resins. Among these, olefine-maleimide copolymer and norbornene resins are particularly preferable owing to their high heat resistance.

The plastic should preferably have a thermal-deformation temperature of 140-360 °C, a coefficient of thermal linear expansion of not greater than 6.2x10⁻⁵ cm/cm·°C, a pencil hardness of not less than 2H, a bending strength of 1,200-2,000 kgf/cm², a modulus of elasticity in bending of 30,000-50,000 kgf/cm², and a tensile strength of 700-1,200 kgf/cm². A plastic with these properties is resistant to high-temperature warping and scratching, and can therefore be used in a wide range of environments.

The plastic preferably has an optical transmittance of not less than 90 %, an Abbe's number of 50-70 and a photoelasticity constant (glass region) of an absolute value of not greater than 10x10⁻¹³ cm²/dyne. A plastic with these properties exhibits high transparency (is bright) and little birefringence (is not likely to produce a double image), and therefore does not degrade the image quality, brightness etc. of the display.

The metallic layer in this invention is not particularly limited regarding type, color, thickness or method of formation insofar it imparts electromagnetic radiation shielding capability and can be etched. Preferable examples include a single layer or two or more laminated layers of copper, nickel, iron, chromium, titanium, aluminum, gold and silver, of a resistivity of 1.0x10⁻⁴Ωcm or less. Among these, copper is particularly preferable from the points of shielding property (resistivity), etchability and price. From the viewpoint of corrosion resistance, the metallic layer preferably has a structure of copper sandwiched between layers of a highly corrosion-resistant metal like chromium or nickel. In general, the shielding performance of the metallic layer improves with increasing conductivity (smaller specific resistance), the shielding performance thereof improves with increasing thickness, and the etchability thereof improves with increasing thinness.

Good shielding performance and etchability are hard to achieve simultaneously when the resistivity exceeds 1.0x10⁻⁴Ωcm.

The metallic layer is formed by dry plating, e.g., by one or a combination of two or more of ion plating, sputtering and vacuum deposition as appropriate for the required thickness, adhesion and the like.

The pattern and aperture ratio of the metallic layer are not particularly limited insofar as they are within ranges ensuring sufficient electromagnetic radiation shielding performance and optical transmittance. Even a parallel line pattern, for example, provides shielding effect (exhibiting directionality in the near field). Since the effect is insufficient, however, a mesh pattern is ordinarily used. Various basic mesh patterns are available, including grid (tetragonal), triangular, polygonal, circular and elliptical.

The aperture ratio (the ratio of the non-metallic portion area relative to the repeated pattern unit area) is determined by the line width and interval (opening width) of the metallic layer. Different patterns with the same aperture ratio have the same optical transmittance. Since the electromagnetic radiation shielding performance increases with decreasing opening width, however, a narrower opening width is ordinarily preferable.

In the case of a grid, the opening width is preferably less than 200 µm, more preferable 100 µm or less. The opening width can be reduced to any value within the range in which patterning is possible. Therefore, no lower limit is defined. In consideration of the lower limit of the line width, the aperture ratio and the like, however, the lower limit of the opening width is generally around 10 µm.

When the opening width is expanded, the shielding performance always decreases if the aperture ratio (optical transmittance) is increased. When the opening width is narrowed, enhanced shielding performance can be achieved simultaneously with an increase in the aperture ratio (optical transmittance).

The line width is preferably 50 µm or less, more preferably 25 µm or less. Setting the opening width and the aperture ratio automatically sets the line width. No particular lower limit is set for the line width. In consideration of patternability and the like, however, the lower limit of line width is generally around 2 µm.

The line thickness is preferably 10 µm or less, more preferably 5 µm or less. In consideration of patternability, viewing angle and the like, the aspect ratio (line thickness/line width) is ordinarily set at 0.5 or less (because patternability decreases and viewing angle narrows with increasing aspect ratio). No particular lower limit is set for the line thickness. In consideration of shielding performance and the like, however, the lower limit of line thickness is generally around 0.5 µm.

The final values are, however, decided to fall within ranges that do not cause occurrence of Moiré fringes when the transparent electromagnetic radiation shield material is disposed on the front of the display panel.

The black metallic oxide (this term referring to a "metallic oxide that is black" not to an "oxide of a black metal) layer of the invention is formed to obtain clarity (viewability), including such aspects of clarity as antireflection property and the like. It is imparted to (laminated on) the metallic layer and is not a portion (the surface layer) of the metallic layer blackened by oxidation treatment.

Any black metallic oxide having sufficient blackness and capable of patterning can be used irrespective of type, thickness or forming method. Preferable examples include oxides of one or a combination of two or more metals such as copper, nickel, cobalt, iron, palladium, platinum, indium, tin, titanium, chromium and the like. Among them, copper oxide, tin oxide and chromium oxide are particularly preferable from the aspects of etching workability and price.

Some metallic oxide layers (mostly ones with electrical insulating property) have low conductivity (e.g., one made of tin oxide etc.). Such metallic oxide layers cannot readily provide good shielding performance and are clearly distinguished from the metallic layer as regards purpose and conductivity.

The thickness of the black metallic oxide layer is preferably 0.01-1 µm, more preferably 0.05-0.5 µm. At less than 0.01 µm, many pinholes occur and blackness is insufficient. At greater than 1 µm, the processing cost is high.

The black metallic oxide layer can be formed by one or a combination of two or more of vacuum deposition, sputtering, ion plating and the like.

When the black metallic oxide layer or the metallic layer is laminated on the transparent base material through an intervening transparent adhesive, the transparent adhesive can be selected from among, for example, polyvinylacetal, acrylic, polyester, epoxy, cellulose and vinyl acetate type polymer adhesives. The thickness of the adhesive layer is generally 1 µm or greater, preferably about 5-500 µm.

The black metallic oxide layer of the laminated article preferably has a degree of blackness, expressed as optical density, of 2.9 or greater. When the optical density is less than 2.9, clarity of the final transparent electromagnetic radiation shield material is poor owing to the low degree of blackness. (The intensity of metallic glare increases with decreasing optical density.) When the optical density is 2.9 or greater, the degree of blackness is sufficiently high and clarity good (sharp). Clarity as perceived by the naked eye does not improve substantially when the optical density exceeds 4.0.

Although the two layers (the black metallic oxide layer and metallic layer or the metallic layer and black metallic oxide layer) laminated on the transparent base material can be given identical aligned mesh patterns by direct processing with a laser beam or the like after laminating the two layers, ordinarily either (A) blasting and/or etching or (B) liftoff is used for this purpose:
(A) In the case of blasting and/or etching, a mesh-like resist portion is first formed after forming the two laminated layers. The resist portion can be formed by a generally known method such as printing or photolithography.
   The two layers are then formed into a mesh pattern corresponding to the resist portion. This can be accomplished by processing the two layers (removing non-resist portions) by a method such as blasting or etching (dissolution with an etching solution). Finally, the resist portion is removed by, for example, soaking in an exfoliating solution such as an aqueous alkali solution or spraying with an exfoliating solution.
   When the two layers are processed by blasting, the surface of the transparent base material or the transparent adhesive layer at the non-resist portions is roughened (whitened) and is therefore preferably coated with a transparent resin to restore transparency. The blasting and etching conditions are not particularly defined but can be chosen as appropriate for the type of black metallic oxide layer and metallic layer.
(B) In the case of liftoff, resist is formed on the transparent base material in a reverse-mesh pattern before forming the two laminated layers. Then, after the two layers have been laminated on the transparent base material and the resist, the resist (with the two layers thereon) is peeled off to leave two mesh-like layers on the transparent base material. The method and conditions of forming the resist pattern portion and the peeling method and conditions are the same as those in the case of blasting and/or etching.
   By liftoff, the formation of the two layers into a mesh pattern can be achieved merely by peeling off the resist of reverse-mesh pattern (with the two layers thereon), with no need for blasting, etching or other such processing. The resulting marked reduction in the number of processing steps ensures higher processing precision and yield than in the case of the method utilizing blasting and/or etching.
   To facilitate peeling/removal of the resist (with the two layers thereon), the thickness of the two layers should preferably be 5-0.1 µm, more preferably 3 µm or less. When their thickness exceeds 5 µm, the processability is poor (portions of the two layers at non-resist portions on the transparent base material may also peel). The minimum thickness need not be limited from the processing aspect (processability improves with increasing thinness) but is determined by the required shielding performance. To achieve a thickness of 5 µm or less, the black metallic oxide layer should preferably be one providing a sufficient degree of blackness even when thin. The black metallic oxide layer is ordinarily laminated by ion plating, sputtering, vacuum deposition or other such dry plating method.
   In this way there is fabricated a transparent electromagnetic radiation shield material having a mesh pattern of a metallic layer and black metallic oxide layer or a black metallic oxide layer and metallic layer (in the case of a metallic layer and black metallic oxide layer, the metallic layer being exposed at a grounding portion if necessary). Provision of the grounding portion is required when the shield material is installed on a display or the like. It can be provided by using a commonly known method (blasting etc.) to remove a portion of the black metallic oxide layer (usually at the frame portion) to expose the metallic layer (conductive portion).
   The transparent electromagnetic radiation shield material preferably has an optical transmittance of 65 % or greater and a shielding performance of not less than 40 dB in the range of 30 to 1000 MHz (50 dB or greater at 500 MHz). An optical transmittance of less than 65 % is too dark and a shielding performance of less than 40 dB (30-1000 MHz) is not sufficient for practical applications.

When the foregoing production methods are applied to a transparent film to fabricate a transparent electromagnetic radiation shield film, the transparent electromagnetic radiation shield film is thereafter laminated to a display panel or a transparent base plate, using an intervening transparent adhesive if necessary, to fabricate a transparent electromagnetic radiation shield panel. The transparent film, is preferably one constituted as a continuous web that can be continuously processed into a roll. Such films include plastic films having a thickness in the approximate range of 5-300 µm made of polyethylene terephthalate (PET), polyimide (PI), polyethersulfone (PES), polyether-etherketone (PEEK), polycarbonate (PC), polypropylene (PP), polyamide, acrylic resin, cellulose propionate (CP), and cellulose acetate (CA).

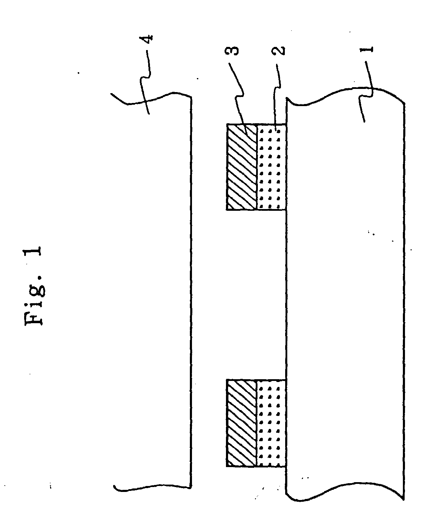

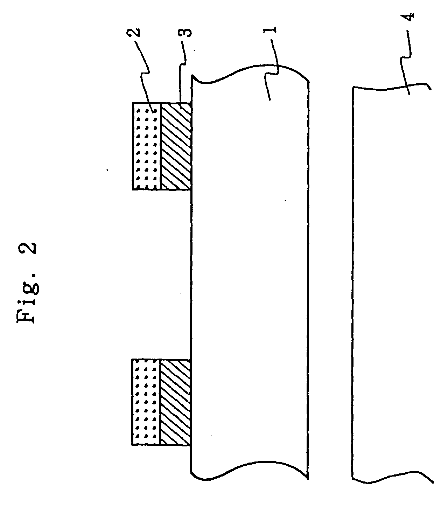

Examples of transparent electromagnetic radiation shield materials provided by the invention will now be explained with reference to Figures 1 and 2.

Figures 1 and 2 show the sectional configurations of the shield materials. The shield material of Figure 1 is composed of a black metallic oxide layer 2 and a metallic layer 3 successively formed in identical laminated mesh-like configuration on a transparent base plate 1 by ion plating. The shield material of Figure 2 is composed of a metallic layer 3 and a black metallic oxide layer 2 also successively formed in identical laminated mesh-like configuration by ion plating. In both examples, the metallic layer 3 of the two layers is located on the side of a display 4.

The invention will now be explained more specifically with reference to working examples.

### Example 1.

An ion-plated (IP) tin oxide layer (black metallic oxide layer: 0.5 µm) and an IP copper layer (metallic layer: 1.5 µm) were successively formed on a glass plate by ion plating. Etching resist was then formed on the metallic layer in a grid-like pattern (line width: 20 µm, line interval: 180 µm, thickness: 5 µm). The formed article was next soaked in etching solution (aqueous solution of 20 % ferric chloride and 1.75 % hydrochloric acid) for 1 min at normal room temperature to remove the metallic layer and black metallic oxide layer at the non-resist portions and the resist pattern was peeled off to afford a transparent electromagnetic radiation shield material (having the same patterning, line width and line interval as the resist pattern).

The electromagnetic radiation shield material exhibited high shielding performance of 60 dB (500 MHz) and transparency (optical transmittance) of 75 %. It was also excellent in clarity (the black layer was high in degree of blackness and free of unevenness) and had a broad viewing angle.

### Example 2.

A transparent electromagnetic radiation shield material was fabricated in the same manner as in Example 1, except that the order of the IP treatment was reversed (i.e., the IP copper was formed on the glass plate first and the IP tin oxide was then formed on the IP copper). The transparent electromagnetic radiation shield material exhibited good performance like that of Example 1.

### Examples 3 and 4.

Transparent electromagnetic radiation shield materials were fabricated in the manner of Example 1 without changing the aperture ratio of the grid-like pattern from that in Example 1 (line width: 20 µm, line interval: 180 µm, aperture ratio: 81 %) but with the line width and line interval narrowed to 1/2 (Example 3) and 1/4 (Example 4).

A comparison of the electromagnetic radiation shield materials obtained in Examples 1, 3 and 4 showed that shielding performance increased with narrower line interval (opening width).

### Examples 5.

A transparent electromagnetic radiation shield material was fabricated in the manner of Example 1, except that the aperture ratio of the grid-like pattern was increased to obtain an electromagnetic radiation shield material with narrower line interval and width (line width: 3 µm, line interval: 45 µm, aperture ratio: 87 %).

This electromagnetic radiation shield material was superior to that of Example 1 in transparency (optical transmittance) and shielding performance.

### Examples 6.

In order to fabricate a transparent electromagnetic radiation shield material like that of Example 1 using the liftoff process, resist was formed on the glass plate in a reverse-grid-like pattern, the two layers were laminated in the manner of Example 1, the result was immersed in a defoliating solution, and the resist (with the two layers thereon) was removed by peeling.

This electromagnetic radiation shield material was superior to that of Example 1 in degree of finish (processing precision). Its other performances were the same as that of Example 1. As the method of this example involves many fewer processing steps and achieves higher yield that of Example 1, it can provide a low-cost product.

### Example 7.

A transparent electromagnetic radiation shield material was fabricated in the manner of Example 1, except that a polyethylene terephthalate (PET) film was used in place of the glass plate.

The transparent electromagnetic radiation shield material exhibited good performance like that of Example 1. Clarity was particularly good when the electromagnetic radiation shield material was laminated directly on the display panel. (A shield material having a mesh-like pattern can be spaced from the display panel up to a distance than does not cause blurring to an annoying degree, but since blurring increases with increasing distance, the clarity is inferior to that in the case of direct lamination.)

### Example 8.

A transparent electromagnetic radiation shield material was fabricated in the manner of Example 1, except that a PET film was used in place of the glass plate and the metallic layer was not formed of a single IP copper layer (1.5 µm) but of three layers: an IP chromium layer (0.1 µm), an IP copper layer (1.5 µm) and an IP chromium layer (0.1 µm).

The transparent electromagnetic radiation shield material exhibited good performance like that of Example 1. When a panel obtained by laminating the electromagnetic radiation shield material onto a transparent plate was tested, it was found to exhibit chromium luster and excellent clarity even when spaced apart from the display panel as in the case of Example 1. (Copper luster tends to degrade image quality.)

The sandwiching of the copper layer between the chromium layers not only provided the early enhancement in shielding performance but by imparting corrosion resistance also improved the long-term stability of the shielding performance.

### Example 9.

A transparent electromagnetic radiation shield material was fabricated in the manner of Example 8, except that the black metallic oxide layer and the metallic layer were formed by sputtering (SP) rather than ion plating (IP). The transparent electromagnetic radiation shield material exhibited good performance like that of Example 8.

### Comparative Example 1.

A copper foil (9 µm) was laminated on a PET film via a transparent acrylic resin adhesive and was then etched into a grid-like pattern by the method of Example 2. Electroplating with blackish nickel (1-1.5 µm) was then conducted to obtain a transparent electromagnetic radiation shield material with a gray-to-black copper foil pattern surface.

The shielding performance of this electromagnetic radiation shield material was excellent ― as good as or better than that in Example 2 ― but its clarity was markedly poorer than that in Example 2 owing to the insufficient and uneven degree of blackness of the copper foil pattern surface. Its transparency (optical transmittance) was also lower than that in Example 2 (even when a transparent resin coating was formed after etching and electroplating) because the black electrodeposited layer was also deposited on the side surface of the copper foil pattern (thereby reducing the aperture ratio). (When no transparent resin coating was formed, the optical transmittance was extremely low because transparency was degraded by back-transfer of the copper foil roughness to the adhesive surface region after etching and electroplating.) In addition, the black electrodeposited material was from place to place deposited over the entire aperture portion (clogging occurred), making the appearance unacceptable (black spot defects).

### Comparative Example 2.

A transparent electromagnetic radiation shield material was fabricated in the manner of Comparative Example 1, except that instead of laminating the copper foil on the PET film, an IP copper layer (1.5 µm) was formed directly on the PET film. The shielding performance of this electromagnetic radiation shield material was excellent ― on a par with that in Example 2 ― but its clarity was about the same as that in Comparative Example 1, i.e., markedly poorer than that in Example 2. Its transparency (optical transmittance) was higher than that in Comparative Example 1 by an amount attributable to the absence of the adhesive layer and the transparent resin coating but lower than that in Example 2 because, like in Comparative Example 1, the black electrodeposited layer was also deposited on the side surface of the IP copper pattern. Moreover, as in Comparative Example 1, many defects in appearance were observed after formation of the black electrodeposited layer.

### Comparative Example 3.

A copper foil (9 µm) was laminated on a PET film via a transparent acrylic adhesive, the surface of the copper foil was made brown-black by chemical treatment (a copper oxide layer was formed to a depth of 2-3 µm from the copper foil surface), and the copper foil was formed into a grid-like pattern by the method of Example 2 to afford a transparent electromagnetic radiation shield material.

The shielding performance of this electromagnetic radiation shield material was excellent ― as good as or better than that in Example 2 ― but its clarity was markedly inferior to that of Example 2 owing to the insufficient and uneven degree of blackness of the copper foil surface. When formed with a transparent resin coating after etching, its transparency (optical transmittance) was lower than that in Example 2 by an amount attributable to the presence of the adhesive layer and the transparent resin coating.

### Comparative Example 4.

A transparent electromagnetic radiation shield material was fabricated in the manner of Comparative Example 3, except that instead of laminating a copper foil on a PET film, an IP copper layer (1.5 µm) was formed directly on the PET film. The copper oxide layer was formed to a depth of 0.5-1 µm from the IP copper layer surface.

The transparency (optical transmittance) of this electromagnetic radiation shield material was excellent ― on a par with that in Example 2 ― but its shielding performance was markedly inferior to that in Example 2 owing to the reduction of the thickness of the metallic layer to 0.5-1 µm. Clarity was markedly inferior to that in Example 2 because the copper oxide layer was thin (0.5-1 µm) and brown in color.

### Comparative Example 5.

A copper foil (9 µm) chemically treated to form a copper oxide layer (brown-black) to a depth of 2-3 µm from the surface was laminated on a PET film via a transparent acrylic resin adhesive. The copper foil of the laminated article was etched into a grid-like pattern (line width: 40 µm, line interval: 360 µm, aperture ratio 81 %) in the manner of Example 1 and then formed with a transparent resin coating to afford a transparent electromagnetic radiation shield material.

Owing to the broad (360 µm) line interval, the shielding performance of the electromagnetic radiation shield material was lower than that in Comparative Example 3 and Example 1. Clarity and transparency (optical transmittance) were the same as in Comparative Example 3 and poorer than in Example 1.

### Comparative Example 6.

A transparent electromagnetic radiation shield material was fabricated in the manner of Comparative Example 5, except that copper foil had a thickness of 35 µm instead of 9 µm.

Owing to considerable thickness of the copper foil, the electromagnetic radiation shield material exhibited excellent shielding performance on a par with that in Example 1 despite the broad line interval of 360 µm, but its clarity and transparency (optical transmittance) were the same as those in Comparative Example 3 and poorer than those in Example 1.

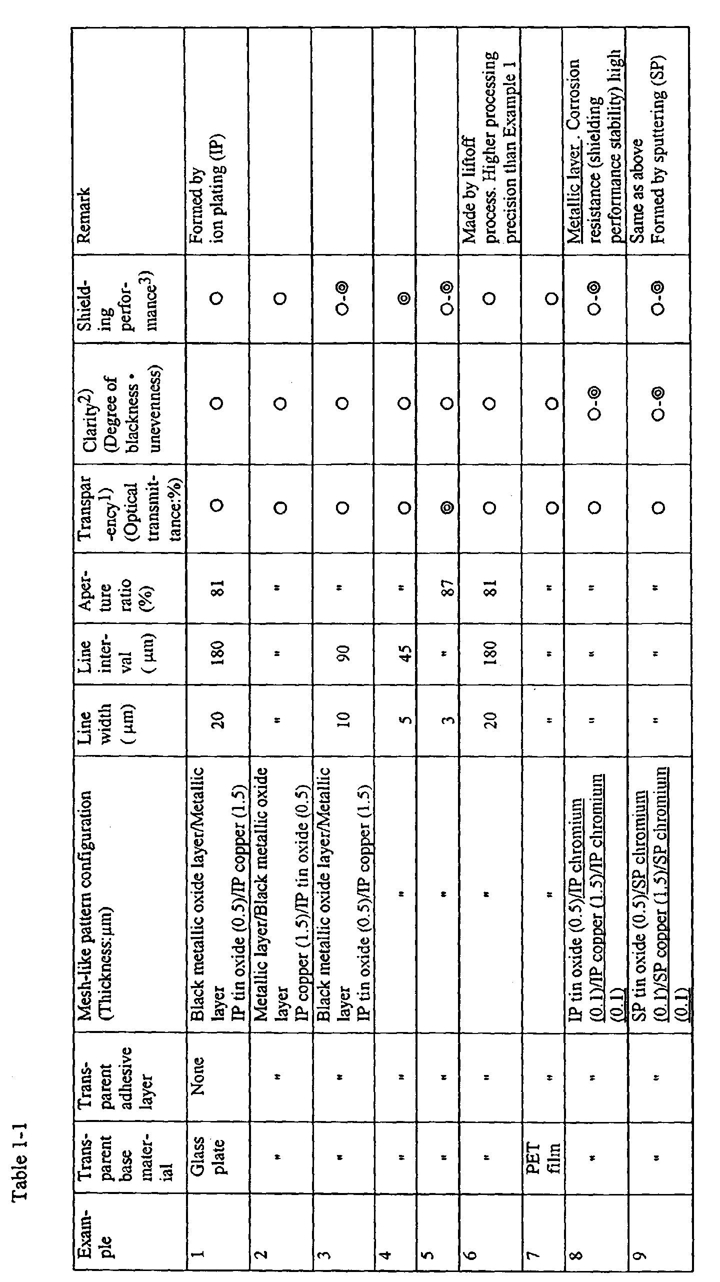

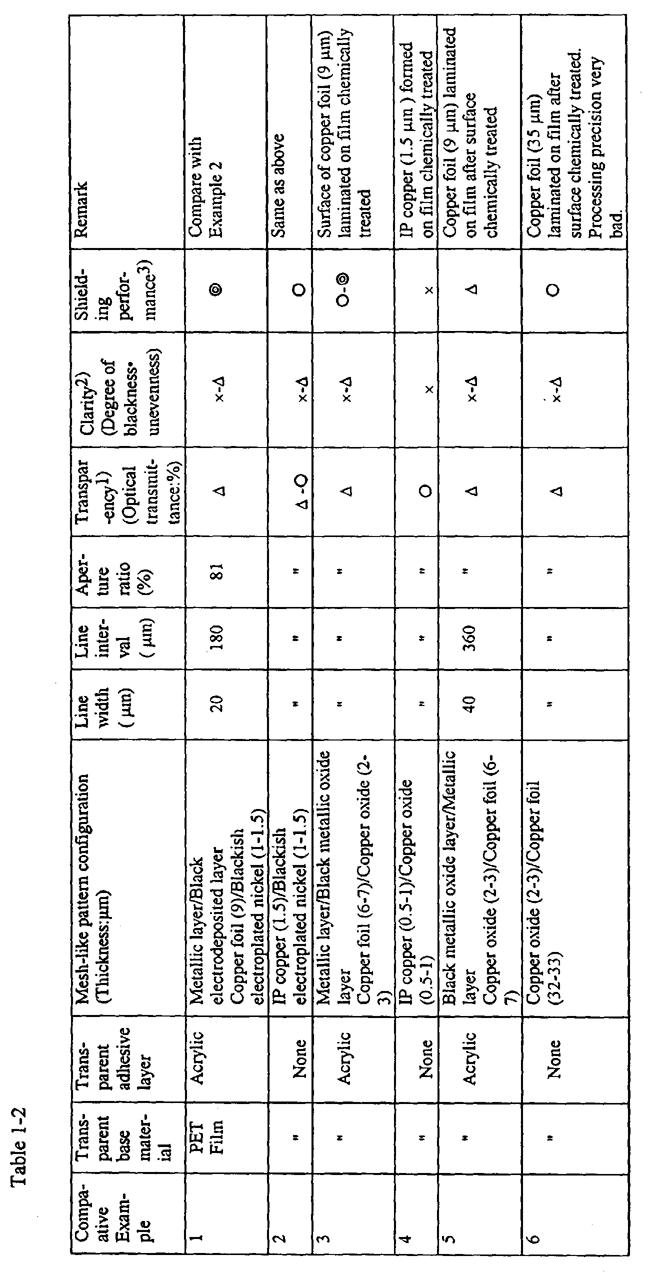

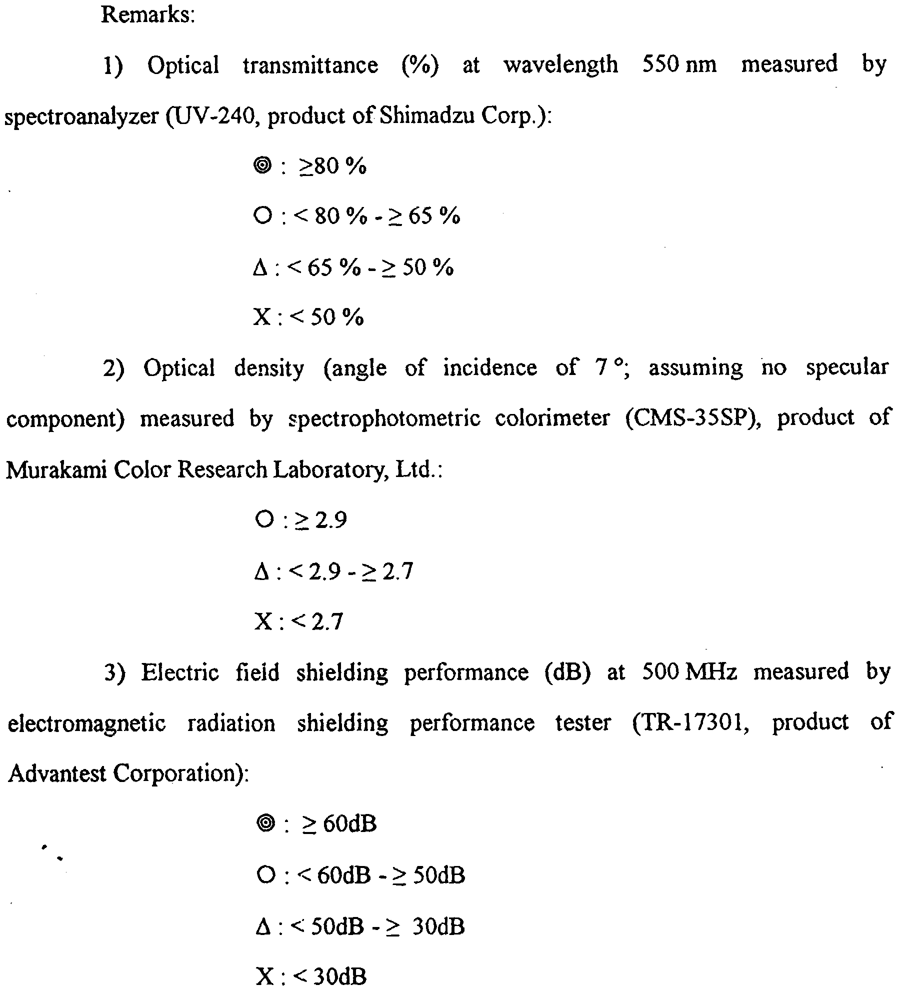

The present invention provides the following advantageous effects:
(1) Pattern design is subject to little restriction.
(2) The degree of blackness and resolution of the black pattern are high, providing outstanding clarity. Long-term stability of these properties is excellent.
(3) An earth lead can be easily connected.
(4) Conductivity of metallic layer is high, shielding effect is high, and high optical transmittance can be obtained since the aperture ratio can be set high. The long-term stability of these properties is excellent.
(5) Metallic layer performance does not decrease even under high-temperature, high-humidity conditions. Stable electromagnetic wave radiation shielding performance can therefore be obtained.
(6) The viewing angle is wide.
(7) Yield is good because the sheets to be laminated to transparent base plates can be cut to different sizes from a web (roll) of the transparent electromagnetic radiation shield film while avoiding inclusion of defective portions.
(8) Curved shields can also be produced.

## Claims

1. A transparent electromagnetic radiation shield material comprising:
a transparent base material; and
a black metallic oxide layer and metallic layer, or a metallic layer and black metallic oxide layer, of identical mesh pattern successively laminated in alignment on the transparent base material by dry plating, a portion of the black metallic oxide layer on the metallic layer optionally being removed.

2. A method of producing a transparent electromagnetic radiation shield material comprising:
a step of successively forming on a transparent base material by dry plating a black metallic oxide layer and metallic layer, or a metallic layer and black metallic oxide layer;
a step of forming a mesh-like resist layer thereon;
a step of removing portions of the black metallic oxide layer and metallic layer or the metallic layer and black metallic oxide layer not protected by the resist layer by sand-blasting and/or dissolution with an etching solution to form a mesh pattern corresponding to the mesh-like resist layer; and
an optional step of peeling off the resist layer and/or coating the mesh-like pattern side (side remote from the transparent base material) with transparent resin.

3. A method of producing a transparent electromagnetic radiation shield material comprising:
a step of forming resist on a transparent base material in a reverse-mesh pattern;
a step of successively forming thereon (on the surface of the transparent base material portion and the resist portion) by dry plating a black metallic oxide layer and metallic layer, or a metallic layer and black metallic oxide layer; and
a step of removing only the black metallic oxide layer and metallic layer, or the metallic layer and black metallic oxide layer, on the resist portion surface by peeling off the resist (liftoff process).
